# EUROPEAN PATENT APPLICATION

(11) **EP 3 855 200 A1**
(43) Date of publication of application: **28.07.2021**
(21) Application number: 20153176.1
(22) Date of filing: 22.01.2020
(51) Int. Cl.: G01R 33/56, G01R 33/561, G06N 3/02

(54) **ARTIFACT AND/OR NOISE REDUCTION FOR MAGNETIC RESONANCE FINGERPRINTING DATA BASED ON A NEURAL NETWORK**

(71) Applicant: Siemens Healthcare GmbH, 91052 Erlangen (DE); Friedrich-Alexander-Universität Erlangen-Nürnberg, 91054 Erlangen (DE)
(72) Inventor: Hoppe, Elisabeth, 91058 Erlangen (DE); Koerzdoerfer, Gregor, 91058 Erlangen (DE); Maier, Andreas, 91054 Erlangen (DE); Xu, Yiling, 91058 Erlangen (DE)

(57) **Abstract**

Methods and devices for fingerprinting magnetic resonance imaging are described. The method comprises acquiring a first sequence of MR data (2000) within a region of interest using a fingerprinting magnetic resonance pulse sequence; inputting the first sequence of MR data to a neural network (3000); outputting a second sequence of MR data from the neural network, wherein the second sequence of MR data have reduced undersampling/aliasing artifacts and/or noise if compared to the first sequence of MR data (4000); determining values of at least one quantitative parameter for the region of interest based on the second sequence of MR data (4000); and constructing a quantitative parameter map of the at least one quantitative parameter for the region of interest based on the determined values.

## Description

### TECHNICAL FIELD

Various examples of the invention generally relate to magnetic resonance (MR) imaging (MRI). Various examples specifically relate to using a magnetic resonance fingerprinting (MRF) protocol and associated reduction of undersampling/aliasing artifacts and/or noise.

### BACKGROUND

Using quantitative MRI, it is possible to determine absolute values of physical observables of the patient. Examples of such quantitative parameters of interest include a longitudinal relaxation time (T1) and a transverse relaxation time (T2). In the clinical routine, quantitative MRI is rarely used. Rather, MRI protocols that are widespread in clinical routine often rely on a relative contrast for the associated MR images. For example, different tissue types will appear in the MR images having a different contrast (sometimes also referred to as weighting). Then, the clinical expert can perform diagnostics based on expert knowledge.

One reason for quantitative MRI not experiencing widespread application in clinical routine is that the associated MRI imaging time, i.e., the time required to acquire the MRI signals using the MRI protocol, is comparably long. To alleviate this drawback, it has been proposed to employ MRF protocols. MRF protocols employ MRF pulse sequences for acquiring the MRI signals. See, e.g. Ma, Dan, et al. "Magnetic resonance fingerprinting." Nature 495.7440 (2013): 187.

MRF generally relies on reconstruction of the MR data. The MRF reconstruction conventionally includes a matching of an evolution of acquired MR signals (fingerprints) with reference fingerprints obtained from a pre-prepared database. The fingerprints can include multiple time points, i.e., MR signals acquired in accordance with a MR fingerprinting pulse sequence. The pre-prepared database is sometimes referred to as dictionary. For example, the dictionary can be populated using simulations. For example, the simulations can be subject to different T1 or T2 relaxation times, tissue types, etc.. Then, based on said matching, it is possible to quantitatively determine the T1 or T2 relaxation times.

MRF is a quantitative imaging technique where MR data for typically multiple highly under-sampled MR images are acquired, with varying acquisition parameters. This defines an MRF sequence for data acquisition. Thereby, a corresponding sequence of MR data is obtained which includes fingerprints for multiple voxels.

Acquisition parameters that are typically varied as a function of the timepoint of the sequence of MR data may include repetition time (TR) and/or flip angles (FA) of excitation pulse. Thereby, the sequence of MR data is obtained (sometimes also referred to as fingerprint). Quantitative maps of multiple physical observables, e.g., the T1 and T2 relaxation times (quantitative parameters), can be reconstructed using the fingerprints.

The MRF protocol often employs heavy undersampling, to speed up the acquisition of the fingerprints. Such undersampling can result in undersampling/aliasing artifacts on the fingerprints. Furthermore, noise is added on the fingerprints.

For determining the quantitative parameters, conventional dictionary-based techniques used are often time and memory consuming. Estimation of values of one or more quantitative parameters (e.g., T1, T2, M0 etc.) of one MR image becomes more and more time-consuming, as the spatial resolution and/or size of the MR image become larger and larger. Accordingly, the parameter estimation becomes a bottleneck for MRF implementations that are sensitive to a variety of acquisition parameters. Furthermore, these approaches are limited to estimate the quantitative parameters at the resolution of the dictionary.

Techniques are known to mitigate these drawbacks. Machine-learning-based methods can be used for MRF reconstruction. Such methods yield a potentially faster matching compared to the conventional exhaustive dictionary matching. See, e.g., Cohen, et al. "Deep learning for fast MR fingerprinting reconstruction." ISMRM, 2017.; Hoppe, et al. "Deep learning for magnetic resonance fingerprinting: Accelerating the reconstruction of quantitative relaxation maps." ISMRM, 2018; Fang, Zhenghan, et al. "Deep Learning for Fast and Spatially-Constrained Tissue Quantification from Highly-Accelerated Data in Magnetic Resonance Fingerprinting." IEEE transactions on medical imaging, 2019.

However, it has been observed that under-sampling artifacts can significantly impair the performance of such MRF reconstruction using machine-learning. Such methods can also fail to generalize. E.g., an artificial neural network (NN) trained on one dictionary or setting of the MRF fingerprinting protocol - e.g., variation scheme of the acquisition parameters, type of echo, etc. - can perform poorly on a different dictionary or setting of the MR fingerprinting protocol.

### SUMMARY

Therefore, a need exists for advanced techniques of performing MRI, in particular MRI using MRF pulse sequences. More specifically, a need exists for techniques of reducing under-sampling/aliasing artifacts and/or noise when performing MRI.

This need is met by the features of the independent claims. The features of the dependent claims define embodiments.

A method for magnetic resonance imaging comprises acquiring a first sequence of MR data within a region of interest using a MRF pulse sequence; inputting the first sequence of MR data to a NN; outputting a second sequence of MR data from the NN, wherein the second sequence of MR data has reduced under-sampling/aliasing artifacts and/or noise if compared to the first sequence of MR data; determining values of at least one quantitative parameter for the region of interest based on the second sequence of MR data; and constructing a quantitative parameter map of the at least one quantitative parameter for the region of interest based on the determined values.

A device (e.g., an MRI scanner) for magnetic resonance imaging comprises one or more processors. The one or more processors acquire a first sequence of MR data within a region of interest using a MRF pulse sequence; input the first sequence of MR data to a NN; output a second sequence of MR data from the NN, wherein the second sequence of MR data has reduced undersampling/aliasing artifacts and/or noise if compared to the first sequence of MR data; determine values of at least one quantitative parameter for the region of interest based on the second sequence of MR data; and construct a quantitative parameter map of the at least one quantitative parameter for the region of interest based on the determined values.

A computer program product or a computer program or a computer-readable storage medium includes program code. The program code can be executed by at least one processor. Executing the program code causes the at least one processor to perform a method of magnetic resonance imaging. The method comprises acquiring a first sequence of MR data within a region of interest using a MRF pulse sequence; inputting the first sequence of MR data to a NN; outputting a second sequence of MR data from the NN, wherein the second sequence of MR data has reduced undersampling/aliasing artifacts and/or noise if compared to the first sequence of MR data; determining values of at least one quantitative parameter for the region of interest based on the second sequence of MR data; and constructing a quantitative parameter map of the at least one quantitative parameter for the region of interest based on the determined values.

It is to be understood that the features mentioned above and those yet to be explained below may be used not only in the respective combinations indicated, but also in other combinations or in isolation without departing from the scope of the invention.

### BRIEF DESCRIPTION OF THE DRAWINGS

- FIG. 1: schematically illustrates an MRI scanner according to various examples.
- FIG. 2: is a flowchart of a method according to various examples.
- FIG. 3: is a flowchart of a method according to various examples.
- FIG. 4: is an exemplary overview of a NN according to various examples.
- FIG. 5: is an overview of a further NN according to various examples.

### DETAILED DESCRIPTION OF EMBODIMENTS

Some examples of the present disclosure generally provide for a plurality of circuits or other electrical devices. All references to the circuits and other electrical devices and the functionality provided by each are not intended to be limited to encompassing only what is illustrated and described herein. While particular labels may be assigned to the various circuits or other electrical devices disclosed, such labels are not intended to limit the scope of operation for the circuits and the other electrical devices. Such circuits and other electrical devices may be combined with each other and/or separated in any manner based on the particular type of electrical implementation that is desired. It is recognized that any circuit or other electrical device disclosed herein may include any number of microcontrollers, a graphics processor unit (GPU), integrated circuits, memory devices (e.g. FLASH, random access memory (RAM), read only memory (ROM), electrically programmable read only memory (EPROM), electrically erasable programmable read only memory (EEPROM), or other suitable variants thereof), and software which co-act with one another to perform operation(s) disclosed herein. In addition, any one or more of the electrical devices may be configured to execute a set of program code that is embodied in a non-transitory computer readable medium programmed to perform any number of the functions as disclosed.

In the following, embodiments of the invention will be described in detail with reference to the accompanying drawings. It is to be understood that the following description of embodiments is not to be taken in a limiting sense. The scope of the invention is not intended to be limited by the embodiments described hereinafter or by the drawings, which are taken to be illustrative only.

The drawings are to be regarded as being schematic representations and elements illustrated in the drawings are not necessarily shown to scale. Rather, the various elements are represented such that their function and general purpose become apparent to a person skilled in the art. Any connection or coupling between functional blocks, devices, components, or other physical or functional units shown in the drawings or described herein may also be implemented by an indirect connection or coupling. A coupling between components may also be established over a wireless connection. Functional blocks may be implemented in hardware, firmware, software, or a combination thereof.

Hereinafter, techniques of MRI described. MRI may be employed to obtain raw MR signals of a magnetization of nuclear spins of a sample region of the patient (MR data). The sample region defines a field of view (FOV) or a region of interest. The MR data are typically defined in k-space. Based on the MR data, MR images in spatial domain can be determined. As a general rule, the term MR image denotes a 2-D or 3-D spatial dataset.

According to various examples, a quantitative MRI pulse sequence may be employed. Hence, the MR images may have a contrast that allows to determine, in absolute numbers, a physical observable (quantitative parameter) such as T1, T2, tissue type contribution (e.g. water content, fat content), etc.. MR images obtained by applying a quantitative MRI pulse sequence are sometimes referred to as parametric maps.

The quantitative MRI pulse sequence can be implemented by an MRF pulse sequence. According to various examples, the MR data are acquired by applying the MRF pulse sequence. Here, typically, a slice of an object (e.g., body of a patient) is scanned multiple times. From timepoint to timepoint of the corresponding sequence of MR data, one or more acquisition parameters (e.g., TR, FA, and/or k-space sampling trajectory) are varied. The variation scheme can be defined by the MRF pulse sequence. For example, an orientation of a k-space trajectory along which the k-space is sampled could be rotated or otherwise varied; the TR and/or FA could be varied between respective minimum and maximum values.

The acquisition yields multiple MR images, e.g., one MR image per timepoint (the timepoints may also be referred to as iterations of the sequence). The MR images are iteratively acquired, i.e. one after another / time-multiplexed. The iterative re-configuration of the one or more acquisition parameters helps to obtain characteristic fingerprints of the response of the nuclear spins for each voxel of the region of interest.

For example, it would be possible that for each voxel of the MR image, a respective fingerprint is included in the sequence of MR data.

Then, it is possible to implement a pattern matching between the sequence of MR data and entries of a dictionary. The pattern matching can be performed for each fingerprint, i.e., on a voxel-by-voxel basis. This allows to construct a quantitative parameter map by repeating the pattern matching process, voxel-by-voxel.

Typically, to speed up the acquisition, each timepoint under-samples the k-space, e.g., only 1/48th of MR data is acquired. This means that - for a given FOV or resolution - the number of k-space samples of the MR data of each timepoint is insufficient to reconstruct the entire image without under-sampling/aliasing artifacts. For example, an echo - e.g. defining a given MR signal - may include a number of samples along a k-space trajectory that is insufficient to reconstruct the MR image at the given FOV and spatial resolution without aliasing.

Hereinafter, techniques for MRF reconstruction are described. According to various examples, it is possible to split the MRF reconstruction into two parts. The first part provides a processing of noisy, heavy undersampling/aliasing artifacts afflicting the fingerprints; and the second part provides quantitative parameters (T1, T2) estimation from the preprocessed fingerprints.

Hereinafter, MRF reconstruction techniques are described that facilitate reducing undersampling/aliasing artifacts and/or noise. The techniques described herein facilitate accurate and reliable MRF reconstruction. The techniques described herein do not require parametrization and or significant prior knowledge; This makes the techniques simple and fast.

This is achieved by using machine-learning in the first part of the MRF reconstruction. In particular, a NN is used to pre-condition the sequence of MR data input in the first stage. Thereby, cleaner fingerprints can be obtained. The pre-conditioned sequence of MR data defines MR images that have reduced undersampling/aliasing artifacts and/or noise.

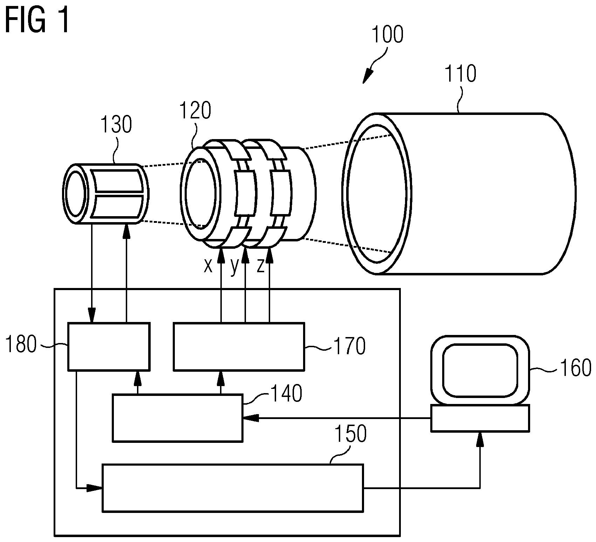

FIG. 1 illustrates aspects with respect to an MRI scanner 100. There are several principal components constituting an MRI scanner 100: the main magnet 110; a set of gradient coils 120 to provide switchable spatial gradients in the main magnetic field; radio frequency (RF) coils 130 (or resonators) for the transmission and reception of radio frequency pulses; pulse sequence electronics 140 for programming the timing of transmission signals (excitation pulse, gradient signals); image reconstruction electronics 150 and a human machine interface 160 for viewing, manipulating, and storing images.

A common type of the main magnet 110 used in MRI systems is the cylindrical superconducting magnet (typically with a 1 meter bore size). The main magnet 110 can provide a main magnet field with a field strength varying from 0.5 Tesla (21 MHz) to 3.0 Tesla (128 MHz), even 9 Tesla (383 MHz), along its longitudinal axis. The main magnetic field can align the magnetization of the nuclear spins of a patient along the longitudinal axis. The patient can be moved into the bore by means of a sliding table (not shown in FIG. 1).

The gradient coils 120 fit inside the bore of the main magnet 110 (after any active shimming coils, if present). The function of the gradient coils 120 is to provide a temporary change in the magnitude of the main magnetic field as a function of position in the bore of the main magnet 110. The gradient coils 120 provide a spatial encoding of the magnetic field strength, to thereby choose slices of the patient body for selective imaging. In this way, MRI can be tomographic - i.e., it can image slices. The gradient coils 120 also provide the means to spatially encode the voxels within a given image slice so that the individual echoes coming from each voxel can be discriminated and turned into an MR image. There are usually three orthogonal gradient coils, one for each of the physical x, y, and z directions. The gradients can be used for slice selection (slice-selection gradients), frequency encoding (readout gradients), and phase encoding along one or more phase-encoding directions (phase-encoding gradients). Hereinafter, the slice-selection direction will be defined as being aligned along the Z-axis; the readout direction will be defined as being aligned with the X-axis; and a first phase-encoding direction as being aligned with the Y-axis. A second phase-encoding direction may be aligned with the Z-axis. The directions along which the various gradients are applied are not necessarily in parallel with the axes defined by the gradient coils 120. Rather, it is possible that these directions are defined by a certain k-space trajectory which, in turn, can be defined by certain requirements of the respective MRI pulse sequence and/or based on anatomic properties of a patient. The gradient coils 120 usually coupled with the pulse sequence electronics 140 via gradient amplifiers 170.

RF pulses that are oscillating at the Larmor frequency applied around a sample causes nuclear spins to precess, tipping them toward the transverse plane. Once a spin system is excited, coherently rotating spins can induce RF currents (at the Larmor frequency) in nearby antennas, yielding measurable signals associated with the free induction decay and echoes. Thus, the RF coils 130 serve to both induce spin precession and to detect signals indicative of the precession of the nuclear spins. The RF coils 130 usually coupled with both the pulse sequence electronics 140 and the image reconstruction electronics 150 via RF electronics 180, respectively.

For creating such RF pulses, an RF transmitter (e.g., a part of the RF electronics 180) is connected via an RF switch (e.g., a part of the RF electronics 180) with the RF coils 130. Via an RF receiver (e.g., a part of the RF electronics 180), it is possible to detect the induced currents or signals by the spin system. In particular, it is possible to detect echoes; echoes may be formed by applying one or more RF pulses (spin echo) and/or by applying one or more gradients (gradient echo). The respectively induced currents or signals can correspond to raw MR data in k-space; according to various examples, the MR data can be processed using MRF reconstruction in order to obtain MR images. Such MRF post-processing can include an Inverse Fourier Transform (IFT) from k-space to spatial space. Such post-processing can also include procedures to reduce undersampling/aliasing artifacts and/or noise. To reconstruct quantitative MR maps, a matching of a sequence of MR data with entries obtained from a pre-prepared database can be employed voxel-by-voxel. Alternatively, other methods, such as a using NN can be used as part of the MRF reconstruction.

Generally, it would be possible to use separate coil assemblies for applying RF pulses on the one hand and for acquiring MR data on the other hand (not shown in FIG. 1). For example, for applying RF pulses, a comparably large body coil (not shown in FIG. 1) can be used; while for acquiring MR data, a surface coil assembly including an array of comparably small coils could be used. For example, the surface coil assembly could include 32 individual RF coils and thereby facilitate parallel acquisition techniques (PATs) relying on spatially-offset coil sensitivities. Example PATs are, e.g.,

PATs include, e.g., GRAPPA, see: Griswold MA, Jakob PM, Heidemann RM, Nittka M, Jellus V, Wang J, Kiefer B, Haase A. Generalized autocalibrating partially parallel acquisitions (GRAPPA). Magn Reson Med 2002; 47: 1202-1210.

PATs include, e.g., SENSE, see: Pruessmann, Klaas P., et al. "SENSE: sensitivity encoding for fast MRI." Magnetic resonance in medicine 42.5 (1999): 952-962.

PATs include, e.g., CAIPIRINHA, see: Breuer, Felix A., et al. "Controlled aliasing in volumetric parallel imaging (2D CAIPIRINHA)." Magnetic Resonance in Medicine: An Official Journal of the International Society for Magnetic Resonance in Medicine 55.3 (2006): 549-556.

The human machine interface 160 might include at least one of a screen, a keyboard, a mouse, etc. By means of the human machine interface 160, a user input can be detected and output to the user can be implemented. For example, by means of the human machine interface 160, it is possible to select and configure the scanning pulse sequence, graphically select the orientation of the scan planes to image, review images obtained, and change variables in the pulse sequence to modify the contrast between tissues. The human machine interface 160 is respectively connected to the pulse sequence electronics 140 and the image reconstruction electronics 150, such as an array processor, which performs the image reconstruction.

The pulse sequence electronics 140 may include a GPU and/or a CPU and/or an application-specific integrated circuit and/or a field-programmable array. The pulse sequence electronics 140 may implement various control functionality with respect to the operation of the MRI scanner 100, e.g. based on program code loaded from a memory. For example, the pulse sequence electronics 140 could implement a sequence control for time-synchronized operation of the gradient coils 120, both the RF transmitter and the RF receiver of the RF electronics 180.

The image reconstruction electronics 150 may include a GPU and/or a CPU and/or an application-specific integrated circuit and/or a field-programmable array. The image reconstruction electronics 150 can be configured to implement post-processing for reconstruction of MR images. For example, a matching of an evolution of acquired MR data (fingerprints) with reference fingerprints obtained from a pre-prepared database (or dictionary) may be employed. The image reconstruction electronics 150 can also perform reduction of under-sampling/aliasing artifacts and/or noise. The image reconstruction electronics 150 can execute NNs, etc..

The pulse sequence electronics 140 and the image reconstruction electronics 150 may be a single circuit, or two separate circuits.

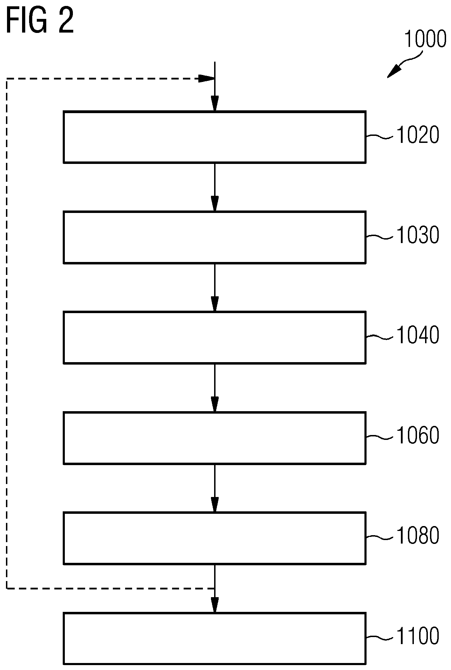

Details with respect to the functioning of the image reconstruction electronics 150 are described in FIG. 2.

FIG. 2 is a flowchart of a method 1000 according to various examples. For example, the method 1000 according to FIG. 2 may be executed by the image reconstruction electronics 150 of the MRI scanner 100 according to the example of FIG. 1, e.g., upon loading program code from a memory. It would also be possible that the method 1000 is at least partially executed by a separate compute unit, e.g. at a server backend.

FIG. 2 illustrates aspects with respect to an MRF protocol. FIG. 2 illustrates aspects with respect to acquisition of MR data using a corresponding MRF pulse sequence. FIG. 2 also illustrates aspects with respect to reconstruction of the acquired MR data, in particular using a 2-step approach. The first step of the 2-step approach includes applying a NN; optionally, in the second step of the 2-step approach it would also be possible to apply a further NN. The method of FIG. 2 provides for a parameter map of at least one quantitative parameter. The parameter map has a certain resolution (i.e., pixel or voxel density, and optionally density of time samples) and dimensionality, e.g., 2-D or 3-D or 3-D plus time.

In detail, at block 1020, a first sequence of MR data is acquired using an MRF pulse sequence. The MR data is provided for a region of interest (ROI) in a patient.

As a general rule, the first sequence of MR data can include information for a 1D voxel, a 2D slice including multiple voxels in a plane, a 3D region, or even 4D (plus time as a dimension or a dimension like time, e.g., singular value decomposition (SVD) compressed along time).

The first sequence of MR data can thus include multiple fingerprints for the voxels in a region of interest.

The first sequence of MR data correspond to raw measurement data. The MR data of the first sequence is typically acquired in k-space. The first sequence of MR data can define multiple MR images in spatial (or image) domain, e.g., after Fourier transformation.

For example, a given timepoint of the first sequence of MR data may correspond to an echo of the nuclear spins. Sampling may be along a k-space trajectory that is defined by gradients.

The first sequence of MR data can be acquired using various MRF pulse sequences, according to various MRF protocols. The MRF pulse sequences may be generally defined with respect to one or more acquisition parameters.

To give a few examples, the one or more acquisition parameters may include: type, shape, amplitude, timing, repetition rate of RF excitation pulses; type, shape, amplitude, timing, repetition rate of inversion pulses; type, amplitude, timing, shape of gradients; readout intervals; k-space trajectory (sometimes also referred to as sampling scheme); under-sampling factor (sometimes also referred to acceleration factor); slice selection; 3-D imaging properties; etc.

For example, the acquisition parameters may define a steady-state free-precession (SSFP) with a spiral k-space trajectory, undersampling factor 48, region of interest (or field of view) 300 mm2, resolution 1.2 mm, slice thickness 5mm. See, e.g. Jiang Y. et al, MR fingerprinting using fast imaging with steady state precession (FISP) with spiral readout. MRM 2015; and Chung S. et al., Rapid B1+ mapping using a preconditioning RF pulse with TurboFLASH readout, MRM 2010; and Pfeuffer, J. et al, Mitigation of Spiral Undersampling Artifacts in MRF (MRF) by Adapted Interleaf Reordering. ISMRM, 2017.

The method 1000 optionally comprises a compression at block 1030. At block 1030, a compression is applied to the first sequence of MR data, before inputting the - then compressed - MR data to an NN. The compression comprises at least one of a singular value decomposition, a principle component analysis, or a machine-learning compression algorithm.

By means of the compression, the length of the first sequence of MR data can be reduced. This lowers the computational burden imposed by inputting the (compressed) first sequence of MR data to the NN, at block 1040.

For example, it would be possible that the compression is applied for each fingerprint, i.e., on a voxel-by-voxel basis.

At block 1040, the first sequence of MR data is input to a NN. This could be done on a voxel-by-voxel basis. It would also be possible to input the entire first sequence of MR data into the NN.

The NN can be one of supervised learning NNs, semi-supervised learning NNs, unsupervised learning NNs, or reinforcement learning NNs. The NN can be one of convolutional NN, recurrent NN (e.g., long short term memory), or a combination of thereof.

According to various examples, a frequency-domain representation or a spatial-domain representation of the first sequence of MR data is input to the NN.

The input of the NN can accept the frequency-domain representation as raw data in k-space, i.e., the fingerprints for an individual voxel. Then, the NN may be executed multiple times, for each fingerprint. Alternatively, the input can accept the frequency-domain data as 2D or 3D k-space MR images, i.e., multiple fingerprints. It would be possible that the NN is executed once, accepting the sequence of MR data as an input, wherein the sequence of MR data defines multiple MR images in k-space.

Likewise, the spatial-domain representation used as an input to the NN can include the respective fingerprints, i.e., data for individual voxels (after transforming the respective MR images into image domain). The spatial-domain representation used as an input could also be 2D or 3D MR images in image domain. For example, the NN can be executed once, accepting the entire sequence of MR data as an input, the sequence of MR data including multiple MR images in image domain.

In block 1060, a second sequence of MR data is output from the NN, e.g., after one or multiple executions of the NN. The second sequence of MR data has reduced undersampling/aliasing artifacts and/or noise if compared to the first sequence of MR data.

The dimensionality - i.e., 1D, 2D, 3D or 4D - of the second sequence of MR data can be the same as the dimensionality of the first sequence of MR data. Corresponding to the first sequence of MR data, the second sequence of MR data can be 1D, 2D, 3D, or even 4D (plus time as a dimension or a dimension like time, e.g., singular value decomposition (SVD) compressed along time). The second sequence of MR data can correspond to fingerprints without undersampling/aliasing artifacts and/or noise or with reduced undersampling/aliasing artifacts and/or noise. The second sequence of MR data can define MR images without undersampling/aliasing artifacts and/or noise or with reduced undersampling/aliasing artifacts and/or noise in k-space or spatial domain.

According to various examples, the length (first length) of the first sequence of MR data differs from the length (second length) of the second sequence of MR data. I.e., the length per fingerprint can differ.

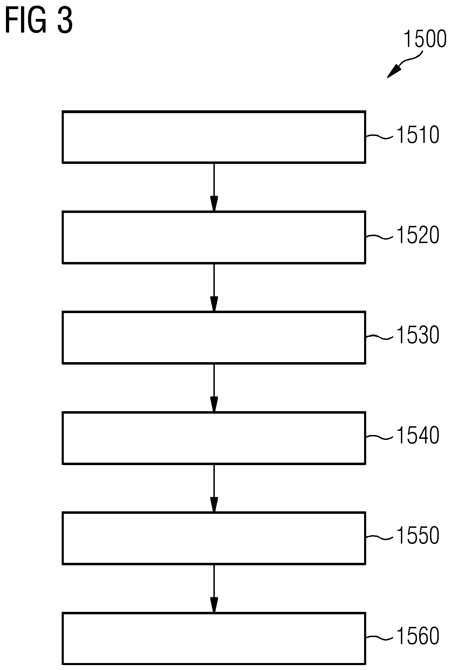

The NN can be trained accordingly, to provide for such a length conversion. Details with respect to the training of the NN will be explained below in connection with FIG. 3.

For example, it would be possible that the second length of the second sequence is longer than the first length of the first sequence. Thereby, it is possible to acquire fewer MR data, thereby shortening the acquisition time. At the same time, accurate matching based on longer fingerprints included in the second sequence of MR data is possible.

It would also be possible that the second length of the second sequence is shorter than the first length of the first sequence. Thereby, applying the NN can provide for a compression which simplifies the further steps of reconstruction, e.g., the matching to the dictionary, at block 1080.

At block 1080, values of at least one quantitative parameter for the region of interest are determined based on the second sequence of MR data. The at least one quantitative parameter comprises at least one of a longitudinal relaxation time (T1), a transverse relaxation time (T2), a proton density (M0), a diffusion, or a perfusion.

According to various examples, the values of the at least one quantitative parameter are determined based on retrieving matched entries of the second sequence of MR data in a predefined fingerprinting dictionary, wherein the matched entries are associated with respective values of the at least one quantitative parameter. Alternatively, the values of the at least one quantitative parameter are determined using a further NN to which the second sequence of MR data are input. The further NN can be one of supervised learning NNs, semi-supervised learning NNs, unsupervised learning NNs, or reinforcement learning NNs. The further NN can be one of convolutional NN, recurrent NN (e.g., long short term memory), or a combination of thereof. The further NN could operate on individual fingerprints of the second sequence of MR data.

The further NN can be used to provide super-resolution. Super-resolution means that the spatial and/or temporal resolution of the inputs to the further NN can be lower than the spatial and/or temporal resolution of the output of the further NN. For example, further slices can be added in a 3-D volume already including some slices, or further pixels could be added within a 2-D slice already including pixels, or both for 3-D (further voxels and slices). For 4-D (3-D plus time), one can do the super-resolution in 3 dimensions: spatial, slices and time.

Thus, as a general rule, resolution of at least one dimension of the quantitative parameter map - determined at block 1100 - can be the same or higher than that of the first sequence of MR data acquired at block 1020. For example, if the quantitative parameter map is 2-D with a resolution 600^{∗}800 pixels, the first sequence of MR data can be a sequence of 2-D MR images, wherein each image has a resolution the same as or smaller than 600^{∗}800 pixels, e.g., 600^{∗}700pixels, 600^{∗}600 pixels, or 500^{∗}500 pixels. Similarly, when the quantitative parameter map is 3-D with 10 slices and each slice has a resolution 600^{∗}800 pixels, the first sequence of MR data can be a sequence of volumes with 10 slices or fewer slices, and each slice can have a resolution that is 600^{∗}800 pixels or less. Thereby, the acquisition time can be reduced.

At block 1100, the quantitative parameter map of the at least one quantitative parameter for the region of interest is constructed based on the determined values in block 1080. The constructed quantitative parameter map of the at least one quantitative parameter can be any of a T1 map, a T2 map, an M0 map, etc.. The constructed quantitative parameter map has no or no significant undersampling/aliasing artifacts and/or noise.

It is possible to add dimensionality for the quantitative parameter map by re-executing blocks 1020-1080 (dashed line in FIG. 2), i.e., by acquiring further sequences of MR data.

Finally, the quantitative parameter map can be output, e.g., via the HMI 160.

By utilizing the NN at block 1040 to reduce noise or artifacts in the measured MR data (e.g., the first sequence of MR data), such as, undersampling/aliasing artifacts and/or noise, clean MR data (e.g., fingerprints, 2D or 3D images in k-space or spatial domain) can be obtained to reconstruct quantitative parameter map. The method 1000 is fully automatically trainable without additional manual annotations. In addition, no hand-crafted optimization like in conventional low-rank or iterative reconstructions is necessary. It is also expectable that this NN-based reconstruction is substantially faster than conventional reconstruction, especially when the acquired datasets are large, for example, are 3D and/or of high spatial resolution, and/or the dictionary used has many parameter dimensions and is of high dictionary resolution. In addition, the method 1000 can generalize to a variety of experimental settings (e.g. pulse sequence, scanner, object/subject) and no manual adaption of reconstruction methods are needed. For example, it can be expected, that a network trained with data from one pulse sequence and sampling scheme could be directly applied to a different pulse sequence (e.g. using different FAs, TRs) and/or sampling schemes.

FIG. 3 is a flowchart of a method 1500 according to various examples. For example, the method 1500 according to FIG. 3 may be executed by the image reconstruction electronics 150 of the MRI scanner 100 according to the example of FIG. 1, e.g., upon loading program code from a memory. It would also be possible that the method 1500 is at least partially executed by a separate compute unit, e.g. at a server backend.

FIG. 3 illustrates aspects with respect to configuring reconstruction of an MRF protocol. In particular, FIG. 3 illustrates aspects with respect to training one or more NNs used for said reconstruction.

The method 1500 is inter-related with the method 1000 of FIG. 2, because the method 1500 provides for the training of the NN used at block 1050.

As such, method 1500 can implement a training phase and method 1000 can implement a subsequent execution phase.

At block 1510, one or more training sequences of MR data are acquired using a training MR fingerprinting pulse sequence.

As a general rule, the training MRF pulse sequence can be different or the same as the MR fingerprinting pulse sequence used for acquiring the first sequence for MR data at block 1020.

As a general rule, the training sequences of MR data can be acquired using a variety of settings (e.g., settings of the training MRF pulse sequences, type of scanners, patients, etc.). Thus, the training MRF pulse sequences can include different FAs, TRs, and/or k-space sampling trajectories or different variations thereof.

It is possible to employ undersampling when acquiring the one or more training sequences of MR data at block 1510. In particular, and undersampling factor and/or an undersampling scheme can be the same for the training MR fingerprinting pulse sequence, as for the MR fingerprinting pulse sequence used at block 1020.

Next, at optional block 1520, MR data is re-constructed, to complement the training sequences of MR data. The reconstruction can employ PAT techniques.

The re-construction can be repeated for each MR image included in the training sequences of MR data.

By reconstructing MR data, undersampling/aliasing artifacts can be removed or reduced.

Block 1520 may not be required if the k-space is fully sampled by the training MR fingerprinting pulse sequence.

At block 1530, the reconstructed training sequences of MR data are matched to the entries of a predefined fingerprinting dictionary. The matching may be executed for each fingerprint included in the training sequences of MR data. For example, for each fingerprint of the reconstructed training sequences of MR data a best-matching entry of the fingerprinting dictionary may be determined using one or more comparisons. See, e.g., Ma, Dan, et al. ("MRF." Nature 495.7440 (2013): 187). Thereby, matched entries of the training sequences of MR data are obtained. By first using PAT to reconstruct MR data, the matching is not negatively affected by the undersampling.

At optional block 1540, it is possible to crop and/or compress the training sequences of MR data acquired at block 1510. This means that the length of the fingerprints of the training sequences of MR data can be reduced. For instance, longer training sequences of MR data may be initially acquired at block 1510, to obtain a better matching at block 1530. On the other hand, it may be desirable to reduce the amount of MR data that needs to be acquired when executing the MRF protocol as part of method 1000. Accordingly, the NN is to be trained based on training sequences being shorter. This is achieved by cropping and/or compressing at block 1540.

As a general rule, the cropping can be implemented randomly or according to certain rules, such as, removing MR data of one timepoint each N timepoints. For example, the MR data of the last M timepoints could be removed.

As a general rule, the compression can use at least one of a singular value decomposition, a principle component analysis, or a machine-learning compression algorithm.

Next, the NN is trained at block 1550. The training is based on the training sequences of MR data acquired at block 1510 - that are optionally shortened at block 1540. The training is further based on the matched entries of the training sequences of MR data as determined at block 1530, as ground truth. The matched entries are clean fingerprints that are used to define the ground truth of the training.

The training of the NN can be performed based on the (optionally compressed and/or cropped) training sequences of MR data having a first length, and the entries of the dictionary having a second length. The second length can be different from the first length, as explained above in connection with block 1060. For example, the second length can be longer than the first length. For example, the first length could be 500 points in time (as defined by Ma, Dan, et al. ("MRF." Nature 495.7440 (2013): 187)), and the second length could be 3000 points in time. Thus, the entries have a higher signal-to-nose ratio (SNR) and are less undersampling/aliasing artifact afflicted, while acquiring a shorter (training) sequences of MR data allows a shorter scanning time.

It has been found that the cropping and/or compressing at block 1540 - as well as the compressing at block 1030 - can affect the contrast of the MR images defined by the respective MR data. This can be taken into account when training the NN at block 1550. This can be taken into account by using a suitable loss function to train the NN. The loss function of the training of the NN has a first sensitivity to feature structure and a second sensitivity to feature contrast, in which the first sensitivity is larger than the second sensitivity. In other words, the loss function can be primarily sensitive to features - e.g., spatial changes of the contrast, patterns, etc. -, rather than to the contrast itself. This facilitates an accurate training of the NN.

According to various examples, a k-space sampling scheme is different for the training MRF pulse sequence if compared to the MRF pulse sequence for acquiring the first sequence of MR data. For example, the training MRF pulse sequence may use full sampling of the k-space, while the MRF pulse sequence for acquiring the first sequence of MR data may use an under-sampling scheme. It would also be possible to use different trajectories: For example, the former may be a spiral sampling scheme, with the later may be a radial sampling scheme.

At block 1560, the further NN - optionally used at block 1080 of method 1000 - may be trained based on the matched entries and the associated values of the at least one quantitative parameter. The further NN can be trained on only simulated data. For example, the simulated fingerprints (or signal evolution) stored in the fingerprinting dictionary can be used as training data of the further NN, and the corresponding values of the at least one quantitative parameter can be the reference data of the training data. The reconstructed 2D or 3D images in k-space or spatial domain can be the training data as well. In addition, measured data can be used to train the further NN, too.

To simplify the training of the further NN, the training can be based on the matched entries as determined at block 1530 only.

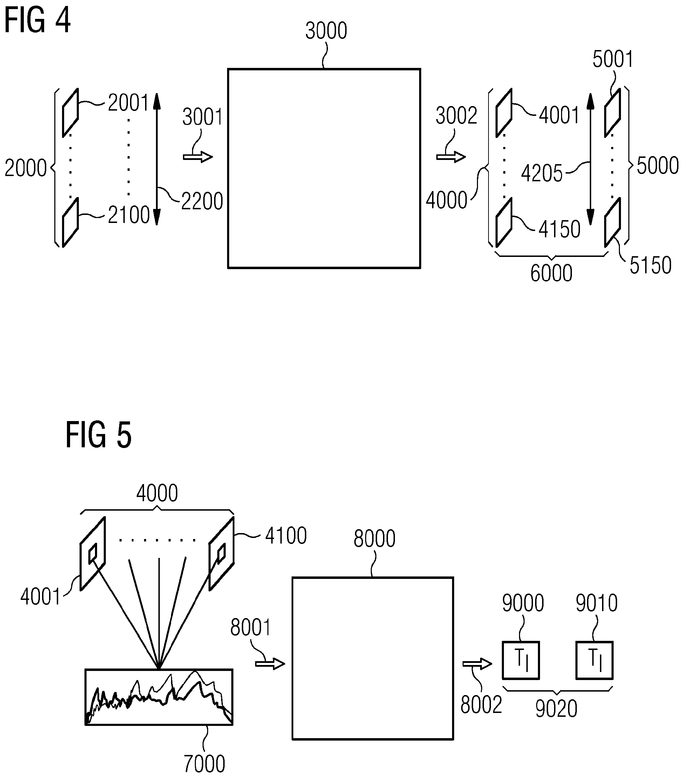

FIG. 4 illustrates aspects with respect to a NN 3000. FIG. 4 illustrates aspects with respect to reduction of under-sampling/aliasing artifacts and/or noise. For example, the NN 3000 of may be used at block 1040 of method 1000. The NN 3000 may be trained at block 1560 of method 1500.

The NN 3000 is a supervised NN having an input 3001 and an output 3001. The input 3001 receives a first sequence 2000 including multiple timepoints 2001-2100. Each timepoint 2001-2100, in the example of FIG. 4, forms a 2-D MR image. Each 2-D MR image may undersample the k-space.

The length 2200 of the sequence 2000 is 100.

The output provides a second sequence 4000 of MR data, also including multiple timepoints 4001-4150. The length 4200 of the second sequence 4000 is 150, i.e., longer than the length 2200.

FIG. 4 also illustrates a reference sequence 5000 of MR data having the same length 4200 as the second sequence 4000. The NN 3000 is trained based on a loss function 6000, i.e., as a difference between the output 3002 of the NN 300 and the reference sequence 5000. The reference sequence 5000 may be built up from multiple fingerprints of the dictionary.

The NN 3000 can have a U-net architecture (See Ronneberger, Olaf, Philipp Fischer, and Thomas Brox. "U-net: Convolutional networks for biomedical image segmentation." International Conference on Medical image computing and computer-assisted intervention. Springer, Cham, 2015.).

FIG. 5 illustrates aspects with respect to the further NN 8000 for determining values of at least one quantitative parameters. The further NN 8000 can be applied at block 1080 of method 1000. The further NN 8000 can be trained at block 1560 of method 1500.

The further NN 8000 is also a supervised NN having input 8001 and an output 8002. The input 8001 receive a signal evolution 7000 of a voxel - i.e., a fingerprint -, which is determined based on the second sequence 4000 obtained from the output 3002 of the NN 3000. The output 9000 provides a parameter (e.g., T1 or T2) value 9000 of that voxel.

FIG. 5 also illustrates a reference 9010 for training the further NN 8000 which is the value of the matched evolution of the input 8001 in a dictionary. The further NN 8000 is trained based on a loss function 9020. The further NN 8000 can be a regression network (e.g., see Zhang, Ying, et al. "Towards end-to-end speech recognition with deep convolutional NNs." arXiv preprint arXiv:1701.02720 (2017).)

Summarizing, NNs based techniques of reducing under-sampling/aliasing artifacts and/or noise in MRI data acquired using MRF sequence pulse have been described. Clear and high quality quantitative parameter maps can be precisely and reliably constructed based on the artifact-reduced MRI data (i.e., the output of the NN).

Although the invention has been shown and described with respect to certain preferred embodiments, equivalents and modifications will occur to others skilled in the art upon the reading and understanding of the specification. The present invention includes all such equivalents and modifications and is limited only by the scope of the appended claims.

## Claims

1. A method of magnetic resonance imaging, comprising:
- acquiring (1020) a first sequence of magnetic resonance data using a magnetic resonance fingerprinting pulse sequence;
- inputting (1040) the first sequence (2000) of magnetic resonance data to a neural network (3000);
- outputting (1060) a second sequence (4000) of magnetic resonance data from the neural network (3000), wherein the second sequence of magnetic resonance data has reduced under-sampling/aliasing artifacts and/or noise if compared to the first sequence of magnetic resonance data;
- determining (1080) values of at least one quantitative parameter based on the second sequence of magnetic resonance data; and
- based on the determined values, constructing (1100) a quantitative parameter map of the at least one quantitative parameter.

2. The method of claim 1, wherein a second length of the second sequence of magnetic resonance data is different from a first length (2200) of the first sequence of magnetic resonance data.

3. The method of claim 1 or 2, wherein the values of the at least one quantitative parameter are determined using a further neural network (8000) to which the second sequence of magnetic resonance data is input.

4. The method of claim 3, wherein a resolution of the quantitative parameter map is higher than a resolution of the second sequence (4000) of magnetic resonance data.

5. The method of any one of the preceding claims, further comprising:
- performing (1510) a training of the neural network (3000) based on training sequences of magnetic resonance data acquired using a training magnetic resonance fingerprinting pulse sequence, and matched entries of the training sequences of magnetic resonance data predefined in a fingerprinting dictionary, wherein the matched entries are associated with respective values of the at least one quantitative parameter.

6. The method of claim 4 and claim 5, the method further comprising:
- performing a training of the further neural network based on the matched entries and the associated values of the at least one quantitative parameter.

7. The method of claim 5 or 6,
wherein the training of the neural network (3000) is performed based on the training sequences of magnetic resonance data having a first length, the matched entries of the fingerprinting dictionary having a second length, the second length being longer than the first length.

8. The method of claim 7, further comprising:
- acquiring (1510) the training sequences of magnetic resonance data having the second length using the training magnetic resonance fingerprinting pulse sequence,
- matching (1530) the training sequences of magnetic resonance data having the second length to the entries of the fingerprinting dictionary, and
- cropping and/or compressing (1540) the training sequences of magnetic resonance data having the second length to the first length for said performing of the training of the neural network (3000).

9. The method of any one of claims 5 to 8,
wherein a loss function of the training of the neural network (3000) has a first sensitivity to feature structure and a second sensitivity to feature contrast,
wherein the first sensitivity is larger than the second sensitivity.

10. The method of any one of claims 5 to 9,
wherein a k-space sampling scheme is different for the training magnetic resonance fingerprinting pulse sequence if compared to the magnetic resonance fingerprinting pulse sequence.

11. The method of any one of the preceding claims, the method further comprises:
- applying a compression to the first sequences of magnetic resonance data before said inputting to the neural network (3000).

12. The method of claim 11, wherein the compression comprises at least one of a singular value decomposition, a principle component analysis, or a machine-learning compression algorithm.

13. The method of any one of the preceding claims, wherein a frequency-domain representation or a spatial-domain representation of the first sequence of magnetic resonance data is input to the neural network (3000).

14. The method of any one of the preceding claims, wherein the at least one quantitative parameter comprises at least one of a longitudinal relaxation time (T1), a transverse relaxation time (T2), a proton density (M0), a diffusion, or a perfusion.

15. A device for magnetic resonance imaging, the device comprising one or more processors, the one or more processors being configured to:
- acquire a first sequence of magnetic resonance data using a magnetic resonance fingerprinting pulse sequence;
- input the first sequence of magnetic resonance data to a neural network (3000);
- output a second sequence of magnetic resonance data from the neural network (3000), wherein the second sequence of magnetic resonance data has reduced undersampling/aliasing artifacts and/or noise if compared to the first sequence of magnetic resonance data;
- determine values of at least one quantitative parameter based on the second sequence of magnetic resonance data; and
- based on the determined values, construct a quantitative parameter map of the at least one quantitative parameter.

16. The device of claim 15, wherein the one or more processors are configured to perform the method of any one of claims 2 to 14.
